# EUROPEAN PATENT SPECIFICATION

(11) **EP 3 001 464 B1**
(45) Date of publication and mention of the grant of the patent: **29.04.2020**
(21) Application number: 15003052.6
(22) Date of filing: 28.09.2012
(51) Int. Cl.: H01L 31/05, H01L 31/0224

(54) **SOLAR CELL MODULE**
SOLARZELLENMODUL
MODULE DE CELLULE SOLAIRE

(30) Priority: 29.09.2011 KR 20110098996
(43) Date of publication of application: 30.03.2016
(62) Divisional of application: 12006774.9
(73) Proprietor: LG Electronics, Inc., Seoul 150-721 (KR)
(72) Inventor: JOE, Jinhyoun, 137-724 Seoul (KR); Choi, Junghoon, 137-724 Seoul (KR); JI, Kwangsun, 137-724 Seoul (KR)
(74) Representative: Katérle, Axel

(56) References cited:
- EP-A2- 2 081 237
- US-A1- 2011 056 550
- US-A1- 2011 073 165
- BULTMAN J H ET AL: "Fast and easy single step module assembly for back-contacted c-Si solar cells with conductive adhesives", PROCEEDINGS OF THE 3RD WORLD CONFERENCE ON PHOTOVOLTAIC ENERGY CONVERSION : JOINT CONFERENCE OF 13TH PV SCIENCE & ENGINEERING CONFERENCE, 30TH IEEE PV SPECIALISTS CONFERENCE, 18TH EUROPEAN PV SOLAR ENERGY CONFERENCE; OSAKA INTERNATIONAL CONGRESS CENT, 18 May 2003 (2003-05-18), pages 979-982Vol.1, XP031987734, ISBN: 978-4-9901816-0-4
- EIKELBOOM D W K ET AL: "CONDUCTIVE ADHESIVES FOR INTERCONNECTION OF BUSBARLESS EMITTER WRAP-THROUGH SOLAR CELLS ON A STRUCTURED METAL FOIL", 17TH. E.C. PHOTOVOLTAIC SOLAR ENERGY CONFERENCE. MUNICH, GERMANY, OCT. 22 - 26, 2001; [PROCEEDINGS OF THE INTERNATIONAL PHOTOVOLTAIC SOLAR ENERGY CONFERENCE], MUNICH : WIP-RENEWABLE ENERGIES, DE, vol. CONF. 17, 22 October 2001 (2001-10-22), pages 1547-1550, XP001139744, ISBN: 978-3-936338-08-9
- EIKELBOOM D W K ET AL: "Conductive adhesives for low-stress interconnection of thin back-contact solar cells", CONFERENCE RECORD OF THE IEEE PHOTOVOLTAIC SPECIALISTS CONFERENCE 2002 INSTITUTE OF ELECTRICAL AND ELECTRONICS ENGINEERS INC. US; [IEEE PHOTOVOLTAIC SPECIALISTS CONFERENCE], CONFERENCE RECORD OF THE 29TH IEEE PHOTOVOLTAIC SPECIALISTS CONFERENCE - 200, vol. CONF. 29, 19 May 2002 (2002-05-19), pages 403-406, XP010666312, DOI: 10.1109/PVSC.2002.1190544 ISBN: 978-0-7803-7471-3

## Description

### BACKGROUND OF THE INVENTION

### Field of the Invention

Embodiments of the invention relate to a solar cell module.

### Description of the Related Art

Recently, as existing energy sources such as petroleum and coal are expected to be depleted, interests in renewable energy sources for replacing the existing energy sources are increasing. As a renewable energy source, solar cells to generate electric energy from solar energy have been particularly spotlighted. A back contact solar cell, in which both an electron electrode and a hole electrode are formed on a back surface of a substrate (i.e., the surface of the substrate on which light is not incident), has been recently developed to increase a light receiving area and improve its efficiency.

The plurality of back contact solar cells each having the above-described structure are connected in series or parallel to one another to manufacture a moisture-proof solar cell module in a panel form, thereby obtaining a desired output.

EP 2 081 237 A2 discloses a solar cell module, in which the first and second solar cells each include p-side and n-side electrodes formed on the back surface, a wiring member connected to the n-side electrode of the first solar cell at a first connecting point and connected to the p-side electrode of the second solar cell at a second connecting point.

### SUMMARY OF THE INVENTION

The present invention provides a solar cell module as defined in the claims. In one aspect, there is a solar cell module including a plurality of back contact solar cells each including a substrate, a plurality of first electrodes, each of which is positioned on a back surface of the substrate and extends in a first direction, and a plurality of second electrodes, each of which is positioned between the two adjacent first electrodes and extends in the first direction, a plurality of first conductive adhesive films, each of which contacts one end of each of the plurality of first electrodes of one of two adjacent back contact solar cells, a plurality of second conductive adhesive films, each of which contacts one end of each of the plurality of second electrodes of another of the two adjacent back contact solar cells, an interconnector which is positioned between the two adjacent back contact solar cells, extends in a second direction perpendicular to the first direction, and electrically connects the plurality of first conductive adhesive films to the plurality of second conductive adhesive films to electrically connect the two adjacent back contact solar cells to each other, a front encapsulant and a back encapsulant configured to protect the plurality of back contact solar cells, a transparent member positioned on the front encapsulant on front surfaces of the substrates of the plurality of back contact solar cells, and a back sheet positioned under the back encapsulant on the back surfaces of the substrates of the plurality of back contact solar cells.

Each of the back contact solar cells may have a non-bus bar structure in which there is no current collector, i.e., bus-bar.

In the back contact solar cell of the non-bus bar structure, adjacent first electrodes are not physically connected to one another due to an electrode material for forming the plurality of first electrodes. Further, adjacent second electrodes are not physically connected to one another due to an electrode material for forming the plurality of second electrodes.

The back contact solar cell of the non-bus bar structure may reduce the manufacturing cost and the number of manufacturing processes resulting from the formation of the bus bar.

Each of the back contact solar cells of the non-bus bar structure may have a heterojunction structure. The substrate of each of the plurality of back contact solar cells of the heterojunction structure is a crystalline semiconductor substrate. A plurality of emitter regions formed of a first amorphous silicon layer and a plurality of back surface field regions formed of a second amorphous silicon layer may be positioned at the back surface of the crystalline semiconductor substrate.

The plurality of first electrodes directly contact the plurality of emitter regions, and the plurality of second electrodes directly contact the plurality of back surface field regions.

Each of the plurality of first electrodes and the plurality of second electrodes may have a uniform width. A width of each of the plurality of first conductive adhesive films may be equal to or less than the width of the plurality of first electrodes, and a width of each of the plurality of second conductive adhesive films may be equal to or less than the width of the plurality of second electrodes.

Unlike the above structure of the solar cell module, the one end of each of the plurality of first electrodes and the one end of each of the plurality of second electrodes may each include a contact part having a width greater than other portions of the plurality of first electrodes and the plurality of second electrodes. A width of each of the plurality of first conductive adhesive films may be equal to or less than the width of the contact part of plurality of the first electrodes, and a width of each of the plurality of second conductive adhesive films may be equal to or less than the width of the contact part of the plurality of second electrodes.

The plurality of first conductive adhesive films do not contact the plurality of second electrodes, and the plurality of second conductive adhesive films do not contact the plurality of first electrodes.

The interconnector may have a slit or a hole and may be formed using a conductive pattern formed on the back sheet.

The interconnector may directly contact the plurality of first conductive adhesive films and the plurality of second conductive adhesive films, or may form an integral body along with the plurality of first conductive adhesive films and the plurality of second conductive adhesive films. Further, the interconnector may directly contact a third conductive adhesive film extending in the second direction.

When the interconnector directly contacts the plurality of first conductive adhesive films and the plurality of second conductive adhesive films, a spacer may be positioned between the two adjacent substrates. The spacer may have a black or white surface. At least one of the front encapsulant and the back encapsulant may be filled in a space between the spacer and the interconnector.

Alternatively, when the interconnector directly contacts the third conductive adhesive film, a width of the third conductive adhesive film may be equal to or less than a width of the interconnector, or may be greater than the width of the interconnector. A length of the third conductive adhesive film may be equal to or greater than a length of the interconnector.

The third conductive adhesive film may have a black or white surface. A thickness of the third conductive adhesive film may be substantially equal to a thickness of one first conductive adhesive film and a thickness of one second conductive adhesive film, or may be greater than the thickness of the one first conductive adhesive film and the thickness of the one second conductive adhesive film.

When the thickness of the third conductive adhesive film is greater than the thicknesses of the first and second conductive adhesive films, the thickness of the third conductive adhesive film may be substantially equal to a sum of a thickness of one first electrode and the thickness of the one first conductive adhesive film or a sum of a thickness of one second electrode and the thickness of the one second conductive adhesive film.

When the interconnector directly contacts the third conductive adhesive film, a spacer may be positioned between the two adjacent substrates. The spacer may have a black or white surface. At least one of the front encapsulant and the back encapsulant may be filled in a space between the spacer and the interconnector.

According to the above-described characteristics of the solar cell module, because a first electrode current collector for physically connecting the first electrodes and a second electrode current collector for physically connecting the second electrodes are removed, material for forming the current collectors may be saved. Thus, the manufacturing cost of the solar cell module may be reduced.

Because the first electrodes and the second electrodes are electrically connected to the interconnector using the first and second conductive adhesive films, the tabbing process may be performed at a low temperature, for example, 140 °C to 180 °C.

In the back contact solar cell having the heterojunction structure, because the emitter region and the back surface field region are formed of amorphous silicon, the emitter region and the back surface field region are easily damaged when a high temperature is applied to the emitter region and the back surface field region in the tabbing process. However, because the tabbing process is performed at a lower temperature in the back contact solar cell according to the embodiment of the invention, the emitter region and the back surface field region formed of amorphous silicon may be prevented from being damaged.

A thin substrate may be used in the solar cell module. For example, when a thickness of the substrate is about 200 µm, a warp amount of the substrate is equal to or greater than about 2.1 mm in a related art tabbing process for melting flux using a hot air. On the other hand, a warp amount of the substrate is about 0.5 mm in the tabbing process using the conductive adhesive film.

The warp amount of the substrate may be expressed by a difference between heights of a middle portion and a peripheral portion of the back surface of the substrate.

The warp amount of the substrate increases as the thickness of the substrate decreases. For example, the thickness of the substrate is about 80 µm, the warp amount of the substrate is equal to or greater than about 14 mm in the related art tabbing process. On the other hand, the warp amount of the substrate is about 1.8 mm in the tabbing process using the conductive adhesive film.

When the warp amount of the substrate exceeds a predetermined value, for example, about 2.5 mm, a crack may be generated in the substrate or bubbles may be generated in the solar cell module in a subsequent lamination process. Therefore, it is impossible to use a thin substrate in the solar cell module manufactured using the related art tabbing process.

On the other hand, the tabbing process using the conductive adhesive film may greatly reduce the warp amount of the substrate, compared with the related art tabbing process. Hence, the thin substrate may be used in the solar cell module.

For example, the substrate having the thickness of about 80 µm to 180 µm may be used in the tabbing process using the conductive adhesive film. Thus, the material cost may be reduced because of a reduction in the thickness of the substrate.

The related art tabbing process may generate the crack at an interface between the current collectors and the interconnector or a peeling phenomenon between several materials inside a solder of the interconnector, thereby reducing the output of the solar cell module. On the other hand, the tabbing process using the conductive adhesive film may solve the above-described problems. Thus, the reliability of the solar cell module may be improved.

Because a thermal stress applied to the interconnector is absorbed by the conductive adhesive film, a damage of the electrical connection between the interconnector and the current collectors resulting from the thermal stress may be prevented or reduced. Hence, the reliability and the durability of the solar cell module may be further improved.

When the interconnector is formed using the conductive pattern formed on the back sheet, a separate tabbing process for tabbing the interconnector to the conductive adhesive film is unnecessary. Further, the number of module processes may be reduced by tabbing the conductive pattern to the conductive adhesive film in the lamination process.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention. In the drawings:
FIG. 1 is a plane view of a solar cell module according to a first embodiment of the invention in a state where a back sheet of the solar cell module is removed;
FIG. 2 is a cross-sectional view taken along line II-II of FIG. 1;
FIG. 3 is a perspective view of a configuration of a back contact solar cell used in a solar cell module according to an example embodiment of the invention;
FIG. 4 is a cross-sectional view of a configuration of a back contact solar cell used in a solar cell module according to another example embodiment of the invention;
FIG. 5 is a partial cross-sectional view of a modification of the solar cell module shown in FIG. 2;
FIG. 6 is a plane view of a solar cell module according to a second embodiment of the invention in a state where a back sheet of the solar cell module is removed;
FIG. 7 is a plane view of a solar cell module according to a third embodiment of the invention in a state where a back sheet of the solar cell module is removed;
FIG. 8 is a cross-sectional view taken along line VII-VII of FIG. 7;
FIG. 9 is a partial cross-sectional view of a first modification of the solar cell module shown in FIG. 8;
FIG. 10 is a partial cross-sectional view of a second modification of the solar cell module shown in FIG. 8;
FIG. 11 is a partial cross-sectional view of a third modification of the solar cell module shown in FIG. 8; and
FIG. 12 is a plane view of a solar cell module according to a fourth embodiment of the invention in a state where a back sheet of the solar cell module is removed.

### DETAILED DESCRIPTION OF THE EMBODIMENTS

Embodiments of the invention will be described more fully hereinafter with reference to the accompanying drawings, in which example embodiments of the invention are shown. This invention may, however, be embodied in many different forms and should not be construed as limited to the embodiments set forth herein. In the drawings, the thickness of layers, films, panels, regions, etc., are exaggerated for clarity. Like reference numerals designate like elements throughout the specification.

It will be understood that when an element such as a layer, film, region, or substrate is referred to as being "on" another element, it can be directly on the other element or intervening elements may also be present.

In contrast, when an element is referred to as being "directly on" another element, there are no intervening elements present. Further, it will be understood that when an element such as a layer, film, region, or substrate is referred to as being "entirely" on other element, it may be on the entire surface of the other element and may not be on a portion of an edge of the other element.

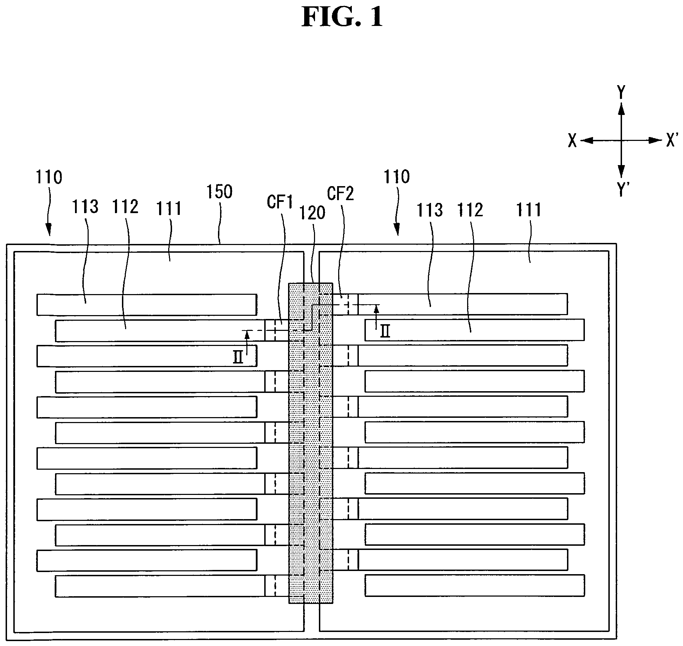

Example embodiments of the invention will be described in detail with reference to FIGS. 1 to 12.

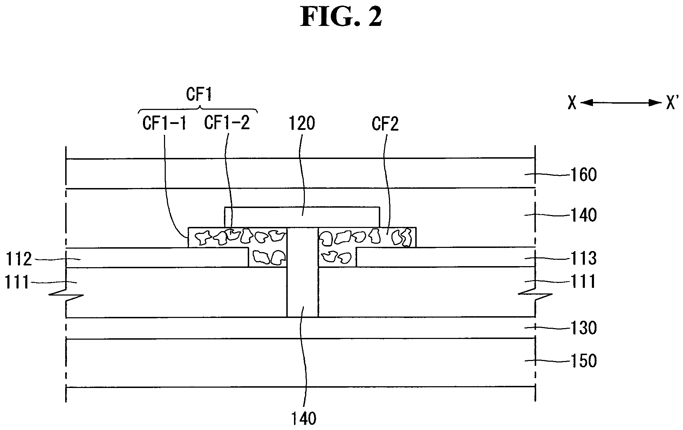

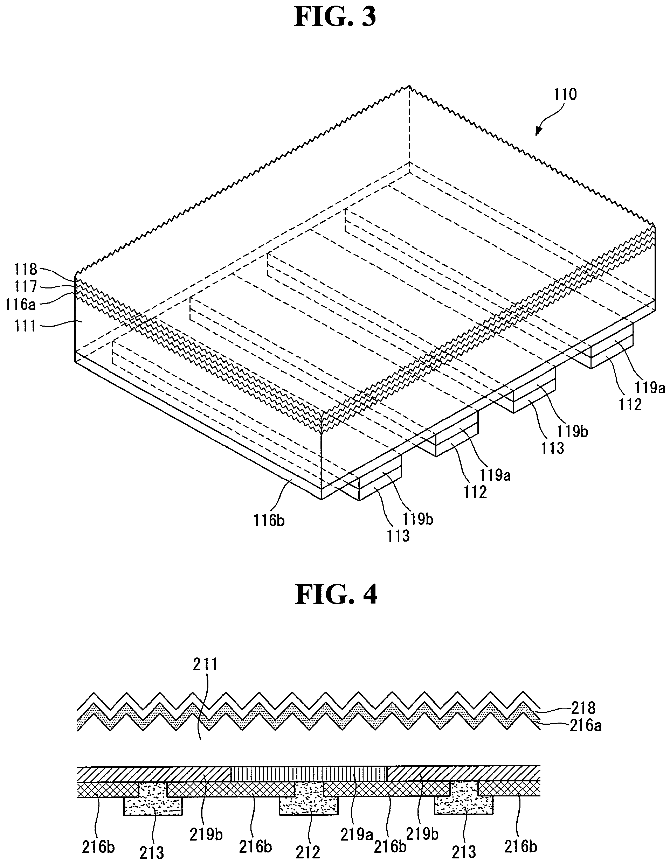

A solar cell module according to a first embodiment of the invention is described in detail with reference to FIGS. 1 to 4. FIG. 1 is a plane view of a solar cell module according to a first embodiment of the invention in a state where a back sheet of the solar cell module is removed. FIG. 2 is a cross-sectional view taken along line II-II of FIG. 1. FIG. 3 is a perspective view of a configuration of a back contact solar cell used in a solar cell module according to an example embodiment of the invention. FIG. 4 is a cross-sectional view of a configuration of a back contact solar cell used in a solar cell module according to another example embodiment of the invention.

As shown in FIGS. 1 to 4, the solar cell module according to the first embodiment of the invention includes a plurality of back contact solar cells 110, an interconnector 120 which is positioned on back surfaces of the back contact solar cells 110 and electrically connects the adjacent back contact solar cells 110 to each other, a front encapsulant 130 and a back encapsulant 140 for protecting the back contact solar cells 110, a transparent member 150 which is positioned on the front encapsulant 130 on light receiving surfaces of the back contact solar cells 110, and a back sheet 160 which is positioned under the back encapsulant 140 on surfaces opposite the light receiving surfaces of the back contact solar cells 110.

Although FIGS. 1 and 2 show only the two back contact solar cells 110, the number of back contact solar cells 110 is not limited thereto.

As shown in FIG. 3, each of the back contact solar cells 110 used in the solar cell module includes a crystalline semiconductor substrate 111, a front passivation layer 116a positioned on an incident surface (hereinafter, referred to as "a front surface") of the crystalline semiconductor substrate 111 on which light is incident, a front surface field (FSF) region 117 positioned at the front passivation layer 116a, an anti-reflection layer 118 positioned on the FSF region 117, a back passivation layer 116b positioned on a surface (hereinafter, referred to as "a back surface"), opposite the incident surface of the crystalline semiconductor substrate 111, on which light is not incident, a plurality of first amorphous silicon layers 119a positioned on the back passivation layer 116b, a plurality of second amorphous silicon layers 119b which are positioned on the back passivation layer 116b to be separated from the plurality of first amorphous silicon layers 119a, a plurality of first electrodes 112 positioned on the plurality of first amorphous silicon layers 119a, and a plurality of second electrodes 113 positioned on the plurality of second amorphous silicon layers 119b.

FIG. 3 shows the back contact solar cell 110 including the FSF region 117, the second amorphous silicon layers 119b, and the back passivation layer 116b. However, the FSF region 117, and the back passivation layer 116b may be omitted, if desired.

Each of the first amorphous silicon layers 119a serves as an emitter region, and each of the second amorphous silicon layers 119b serves as a back surface field (BSF) region. Thus, the first amorphous silicon layer 119a is hereinafter referred to as the emitter region, and the second amorphous silicon layer 119b is hereinafter referred to as the BSF region.

The emitter region and the back surface field region may be formed of a crystalline silicon layer in other embodiments of the invention.

The crystalline semiconductor substrate 111 is the substrate formed of first conductive type silicon, for example, n-type silicon. Silicon used in the crystalline semiconductor substrate 111 may be crystalline silicon such as single crystal silicon and polycrystalline silicon.

When the crystalline semiconductor substrate 111 is of the n-type, the crystalline semiconductor substrate 111 may be doped with impurities of a group V element such as phosphorus (P), arsenic (As), and antimony (Sb).

Alternatively, the crystalline semiconductor substrate 111 may be of a p-type, and/or be formed of semiconductor materials other than silicon. When the crystalline semiconductor substrate 111 is of the p-type, the crystalline semiconductor substrate 111 may be doped with impurities of a group III element such as boron (B), gallium (Ga), and indium (In).

The front surface of the crystalline semiconductor substrate 111 may be textured to form a textured surface corresponding to an uneven surface or having uneven characteristics.

FIG. 3 shows that only edges of the crystalline semiconductor substrate 111, the front passivation layer 116a, the FSF region 117, and the anti-reflection layer 118 have the textured surface for the sake of brevity. However, the entire front surface of each of the crystalline semiconductor substrate 111, the front passivation layer 116a, the FSF region 117, and the anti-reflection layer 118 substantially has the textured surface.

The front passivation layer 116a positioned on the front surface of the crystalline semiconductor substrate 111 may be formed using one of intrinsic amorphous silicon (a-Si), silicon nitride (SiNx), and silicon oxide (SiOx).

The front passivation layer 116a performs a passivation function which converts a defect, for example, dangling bonds existing at and around the surface of the crystalline semiconductor substrate 111 into stable bonds to thereby prevent or reduce a recombination and/or a disappearance of carriers moving to the surface of the crystalline semiconductor substrate 111. Hence, the front passivation layer 116a reduces an amount of carriers lost by the defect at and around the surface of the crystalline semiconductor substrate 111.

When a thickness of the front passivation layer 116a is equal to or greater than about 1 nm, the front passivation layer 116a is uniformly coated on the front surface of the crystalline semiconductor substrate 111, thereby smoothly performing the passivation function. When the thickness of the front passivation layer 116a is equal to or less than about 30 nm, an amount of light absorbed in the front passivation layer 116a is reduced. Hence, an amount of light incident on the crystalline semiconductor substrate 111 may increase. Thus, the front passivation layer 116a may have the thickness of about 1 nm to 30 nm.

The FSF region 117 positioned at the front passivation layer 116a is a region which is more heavily doped than the crystalline semiconductor substrate 111 with impurities of the same conductive type (for example, the n-type) as the crystalline semiconductor substrate 111. An impurity concentration of the FSF region 117 may be about 10¹⁰ to 10²¹ atoms/cm³.

The FSF region 117 may be formed using one of amorphous silicon, amorphous silicon oxide (a-SiOx), and amorphous silicon carbide (a-SiC).

When the FSF region 117 is formed using the above material, a potential barrier is formed by a difference between impurity concentrations of the crystalline semiconductor substrate 111 and the FSF region 117. Hence, an electric effect may be obtained to prevent or reduce the movement of carriers (for example, holes) to the front surface of the crystalline semiconductor substrate 111.

Amorphous silicon oxide (a-SiOx) and amorphous silicon carbide (a-SiC) generally have energy band gaps of about 2.1 and about 2.8, respectively. Thus, the energy band gaps of amorphous silicon oxide (a-SiOx) and amorphous silicon carbide (a-SiC) are greater than amorphous silicon having an energy band gap of about 1.7 to 1.9.

When the FSF region 117 is formed of amorphous silicon oxide (a-SiOx) or amorphous silicon carbide (a-SiC), an amount of light absorbed in the FSF region 117 decreases. Hence, an amount of light incident on the crystalline semiconductor substrate 111 further increases.

The anti-reflection layer 118 positioned on the FSF region 117 reduces a reflectance of light incident on the back contact solar cell 110 and increases selectivity of a predetermined wavelength band, thereby increasing the efficiency of the back contact solar cell 110.

The anti-reflection layer 118 may be formed of silicon nitride (SiNx) or silicon oxide (SiOx), etc. The anti-reflection layer 118 may have a single-layered structure or a multi-layered structure. The anti-reflection layer 118 may be omitted, if desired.

The back passivation layer 116b is positioned directly on the back surface of the crystalline semiconductor substrate 111 and performs the passivation function in the same manner as the front passivation layer 116a, thereby preventing or reducing a recombination and/or a disappearance of carriers moving to the back surface of the crystalline semiconductor substrate 111.

The back passivation layer 116b may be formed of amorphous silicon in the same manner as the front passivation layer 116a.

The back passivation layer 116b has a thickness such that carriers moving to the back surface of the crystalline semiconductor substrate 111 may pass through the back passivation layer 116b and then may move to the emitter regions 119a or the BSF regions 119b.

When the thickness of the back passivation layer 116b is equal to or greater than about 1 nm, the back passivation layer 116b is uniformly coated on the back surface of the crystalline semiconductor substrate 111, thereby further increasing the passivation effect. When the thickness of the back passivation layer 116b is equal to or less than about 10 nm, an amount of light, which passes through the crystalline semiconductor substrate 111 and then is absorbed in the back passivation layer 116b, is reduced. Hence, an amount of light again incident on the crystalline semiconductor substrate 111 may increase.

Thus, the back passivation layer 116b may have the thickness of about 1 nm to 10 nm.

Each of the plurality of BSF regions 119b is a region which is more heavily doped than the crystalline semiconductor substrate 111 with impurities of the same conductive type (for example, the n-type) as the crystalline semiconductor substrate 111. For example, each BSF region 119b may be an n⁺-type region.

The plurality of BSF regions 119b are separated from one another on the back passivation layer 116b and extend parallel to one another in a fixed direction. In the embodiment of the invention, the BSF regions 119b may be formed of non-crystalline semiconductor such as amorphous silicon.

Similar to the FSF region 117, the BSF regions 119b prevent or reduce the movement of holes to the BSF regions 119b and make it easier for electrons to move to the BSF regions 119b using a potential barrier formed by a difference between impurity concentrations of the crystalline semiconductor substrate 111 and the BSF regions 119b.

Accordingly, the BSF regions 119b reduce an amount of carriers lost by a recombination and/or a disappearance of electrons and holes at and around the BSF regions 119b or at the first electrodes 112 and the second electrodes 113 and accelerate a movement of electrons, thereby increasing an amount of electrons moving to the BSF regions 119b.

In the first embodiment of the invention, a first electrode current collector for connecting ends of the first electrodes 112 and a second electrode current collector for connecting ends of the second electrodes 113 are not formed on the back surface of the crystalline semiconductor substrate 111.

In other words, each of the back contact solar cells 110 used in the solar cell module according to the embodiment of the invention has a non-bus bar structure in which there is no current collector, i.e., bus-bar.

In the back contact solar cell 110 of the non-bus bar structure, the first electrodes 112 are not physically connected to one another because of an electrode material for forming the first electrodes 112, and the second electrodes 113 are not physically connected to one another because of an electrode material for forming the second electrodes 113.

The back contact solar cell 110 of the non-bus bar structure may reduce the manufacturing cost and the number of manufacturing processes resulting from the formation of the bus bar.

Each of the BSF regions 119b may have a thickness of about 10 nm to 25 nm. When the thickness of the BSF region 119b is equal to or greater than about 10 nm, the potential barrier preventing the movement of holes may be formed more smoothly. Hence, a loss of carriers may be further reduced. When the thickness of the BSF region 119b is equal to or less than about 25 nm, an amount of light absorbed in the BSF region 119b decreases. Hence, an amount of light again incident on the crystalline semiconductor substrate 111 may increase.

The plurality of emitter regions 119a are separated from the plurality of BSF regions 119b at the back surface of the crystalline semiconductor substrate 111 and extend parallel to the plurality of BSF regions 119b.

Thus, as shown in FIG 3, the plurality of emitter regions 119a and the plurality of BSF regions 119b are alternately positioned at the back surface of the crystalline semiconductor substrate 111.

Each of the plurality of emitter regions 119a positioned at the back surface of the crystalline semiconductor substrate 111 is of a second conductive type (for example, p-type) opposite the first conductive type (for example, n-type) of the crystalline semiconductor substrate 111. The emitter region 119a contains a semiconductor different from the crystalline semiconductor substrate 111, for example, amorphous silicon.

Thus, the emitter regions 119a and the crystalline semiconductor substrate 111 form a heterojunction as well as a p-n junction.

According to the above-described configuration of the back contact solar cell 110, carriers (i.e., electron-hole pairs) produced by light incident on the crystalline semiconductor substrate 111 are separated into electrons and holes by a built-in potential difference resulting from the p-n junction between the crystalline semiconductor substrate 111 and the emitter regions 119a. Then, the separated electrons move to the n-type semiconductor, and the separated holes move to the p-type semiconductor.

Thus, when the crystalline semiconductor substrate 111 is of the n-type and the emitter regions 119a are of the p-type, the separated holes pass through the back passivation layer 116b and move to the emitter regions 119a. Further, the separated electrons pass through the back passivation layer 116b and move to the BSF regions 119b having an impurity concentration higher than the crystalline semiconductor substrate 111.

Each of the plurality of emitter regions 119a may have a thickness of about 5 nm to 15 nm. When the thickness of the emitter region 119a is equal to or greater than about 5 nm, the p-n junction may be formed more smoothly. When the thickness of the emitter region 119a is equal to or less than about 15 nm, an amount of light absorbed in the emitter regions 119a decreases. Hence, an amount of light again incident on the crystalline semiconductor substrate 111 may increase.

The back passivation layer 116b is formed of intrinsic amorphous silicon (a-Si), in which there are no impurities or impurities scarcely exist, and is positioned under the emitter regions 119a and the BSF regions 119b. Therefore, the emitter regions 119a and the BSF regions 119b are not positioned directly on the crystalline semiconductor substrate 111 and are positioned on the back passivation layer 116b. As a result, a crystallization phenomenon is reduced.

Further, characteristics of the emitter regions 119a and the BSF regions 119b positioned on the intrinsic amorphous silicon layer (i.e., the back passivation layer 116b) are improved.

The first electrodes 112 respectively contacting the emitter regions 119a extend along the emitter regions 119a in a first direction X-X' and are electrically connected to the emitter regions 119a. The first electrodes 112 collect carriers (for example, holes) moving to the emitter regions 119a.

The second electrodes 113 respectively contacting the BSF regions 119b extend along the BSF regions 119b in the first direction X-X' and are electrically connected to the BSF regions 119b. The second electrodes 113 collect carriers (for example, electrons) moving to the BSF regions 119b.

Accordingly, the first electrodes 112 and the second electrodes 113 extend parallel to each other along the first direction X-X' at uniform intervals therebetween.

The first and second electrodes 112 and 113 may be formed of at least one conductive material selected from the group consisting of nickel (Ni), copper (Cu), silver (Ag), aluminum (Al), tin (Sn), zinc (Zn), indium (In), titanium (Ti), gold (Au), and a combination thereof. Other conductive materials may be formed.

FIG. 4 is a cross-sectional view of a configuration of a back contact solar cell 210 used in a solar cell module according to another example embodiment of the invention.

The solar cell 210 includes a first conductive type semiconductor substrate 211, a front passivation layer 216a formed in one surface (for example, a light receiving surface) of the semiconductor substrate 211, an anti-reflection layer 218 formed on the front passivation layer 216a, a first doped region 219a that is formed in other surface of the semiconductor substrate 211 and is heavily doped with first conductive type impurities, a second doped region 219b that is formed in the other surface of the semiconductor substrate 211 at a location adjacent to the first doped region 219a and is heavily doped with second conductive type impurities opposite the first conductive type impurities, a back passivation layer 216b exposing a portion of each of the first doped region 219a and the second doped region 219b, a first electrode 212 and a first electrode current collector electrically connected to the exposed portion of the first doped region 219a, and a second electrode 213 and a second electrode current collector electrically connected to the exposed portion of the second doped region 219b.

The front passivation layer 216a formed in the light receiving surface of the semiconductor substrate 211 is a region that is more heavily doped with impurities of a group V element such as phosphorus (P), arsenic (As), and antimony (Sb) than the semiconductor substrate 211. The front passivation layer 216a serves as a front surface field (FSF) layer similar to a back surface field (BSF) layer. Thus, a recombination and/or a disappearance of electrons and holes separated by incident light around the light receiving surface of the semiconductor substrate 211 are prevented or reduced.

The anti-reflection layer 218 on the surface of the front passivation layer 216a is formed of silicon nitride (SiNx) and/or silicon dioxide (SiO₂).

The first doped region 219a formed in the other surface of the semiconductor substrate 211 is a region that is more heavily doped with n-type impurities than the semiconductor substrate 211, and the second doped region 219b formed in the other surface of the semiconductor substrate 211 is a p-type heavily doped region. Thus, the p-type second doped region 219b and the n-type semiconductor substrate 211 form a p-n junction.

The first doped region 219a and the second doped region 219b serve as a moving path of carriers (electrons and holes) and respectively collect electrons and holes.

The back passivation layer 216b exposing a portion of each of the first doped region 219a and the second doped region 219b is formed of silicon nitride (SiNx), silicon dioxide (SiO₂), or a combination thereof. The back passivation layer 216b prevents or reduces a recombination and/or a disappearance of electrons and holes separated from carriers and reflects incident light to the inside of the solar cell so that the incident light is not reflected to the outside of the solar cell. Namely, the back passivation layer 216b prevents a loss of the incident light and reduces a loss amount of the incident light.

The back passivation layer 216b may have a single-layered structure or a multi--layered structure such as a double-layered structure or a triple-layered structure.

The first electrode 212 is formed on the first doped region 219a not covered by the back passivation layer 216b and on a portion of the back passivation layer 216b adjacent to the first doped region 219a not covered by the back passivation layer 216b. The second electrode 213 is formed on the second doped region 219b not covered by the back passivation layer 216b and on a portion of the back passivation layer 216b adjacent to the second doped region 219b not covered by the back passivation layer 216b.

Thus, the first electrode 212 is electrically connected to the first doped region 219a, and the second electrode 213 is electrically connected to the second doped region 219b.

As described above, because a portion of each of the first and second electrodes 212 and 213 overlaps a portion of the back passivation layer 216b and is connected to a bus bar area, a contact resistance and a series resistance generated when the first and second electrodes 212 and 213 contact an external driving circuit, etc., decrease. Hence, the efficiency of the solar cell is improved.

The back sheet 160 prevents moisture and oxygen from penetrating into a back surface of the solar cell module, thereby protecting the back contact solar cells 110 from an external environment. The back sheet 160 may have a multi-layered structure including a moisture/oxygen penetrating prevention layer, a chemical corrosion prevention layer, an insulation layer, etc.

The front encapsulant 130 and the back encapsulant 140 are respectively positioned on and under the back contact solar cells 110 and are attached to each other, thereby forming an integral body along with the back contact solar cells 110. Hence, the front encapsulant 130 and the back encapsulant 140 prevent corrosion of the back contact solar cells 110 resulting from the moisture penetration and protect the back contact solar cells 110 from an impact.

In the embodiment of the invention, the front encapsulant 130 and the back encapsulant 140 may be formed of the same material.

For example, the front encapsulant 130 and the back encapsulant 140 may be formed of a material (for example, cured siloxane containing polydimethylsiloxane (PDMS)) cured by performing a thermal processing on a liquid compound.

When the liquid compound, i.e., liquid siloxane is coated on the back contact solar cells 110, a portion of coated siloxane precursor is filled in a space between the back contact solar cells 110 due to its liquidity and is cured through the thermal processing.

Alternatively, the front encapsulant 130 and the back encapsulant 140 may be formed of a material manufactured in a film type, for example, ethylene vinyl acetate (EVA).

Further, the front encapsulant 130 and the back encapsulant 140 may be formed of different materials.

For example, the front encapsulant 130 may be formed of film type EVA, and the back encapsulant 140 may be formed of cured siloxane.

The transparent member 150 positioned on the front encapsulant 130 is formed of a tempered glass having a high transmittance of light to thereby prevent a damage of the solar cell module. The tempered glass may be a low iron tempered glass containing a small amount of iron. The transparent member 150 may have an embossed inner surface so as to increase a scattering effect of light.

The interconnector 120 is formed of a conductive metal and electrically connects the adjacent solar cells 110 to each other. The interconnector 120 may be formed of a conductive metal of a lead-free material containing lead (Pb) equal to or less than about 1,000 ppm. Alternatively, the interconnector 120 may include a solder formed of a Pb-containing material coated on the surface of the conductive metal.

The interconnector 120 contacts a conductive adhesive film, so as to electrically connect the adjacent solar cells 110 to each other.

In the embodiment of the invention, the conductive adhesive film includes a plurality of first conductive adhesive films CF1, each of which contacts one end of each of the first electrodes 112, and a plurality of second conductive adhesive films CF2, each of which contacts one end of each of the second electrodes 113.

Accordingly, the number of first conductive adhesive films CF1 is equal to the number of first electrodes 112 of one back contact solar cell, and the number of second conductive adhesive films CF2 is equal to the number of second electrodes 113 of one back contact solar cell.

Alternatively, one conductive adhesive film may connect at least two electrodes to each other. For example, when the number of first electrodes 112 is 20, the ten first conductive adhesive films CF1 may be used. In this instance, the ends of the two first electrodes 112 may contact the one first conductive adhesive film CF1.

A bonding structure between the interconnector and the current collector is described in detail below.

The first conductive adhesive film CF1 is positioned on one end of the first electrode 112, and the second conductive adhesive film CF2 is positioned on one end of the second electrode 113.

Configuration of the first conductive adhesive film CF1 is substantially the same as configuration of the second conductive adhesive film CF2. Therefore, only the configuration of the first conductive adhesive film CF1 is described below, and the configuration of the second conductive adhesive film CF2 may be briefly made or may be entirely omitted.

The first conductive adhesive film CF1 includes a resin CF1-1 and a plurality of conductive particles CF1-2 distributed in the resin CF1-1.

A material of the resin CF1-1 is not particularly limited as long as it has the adhesive property. It is preferable, but not required, that a thermosetting resin is used for the resin CF1-1 so as to increase the adhesive reliability.

The thermosetting resin may use at least one selected among epoxy resin, phenoxy resin, acryl resin, polyimide resin, and polycarbonate resin.

The resin CF1-1 may further contain a predetermined material, for example, a known curing agent and a known curing accelerator other than the thermosetting resin.

For example, the resin CF1-1 may contain a reforming material such as a silane-based coupling agent, a titanate-based coupling agent, and an aluminate-based coupling agent, so as to improve an adhesive strength between the first electrode 112 and the interconnector 120.

The resin CF1-1 may contain a dispersing agent, for example, calcium phosphate and calcium carbonate, so as to improve the dispersibility of the conductive particles CF1-2. The resin CF1-1 may contain a rubber component such as acrylic rubber, silicon rubber, and urethane rubber, so as to control the modulus of elasticity of the first conductive adhesive film CF1.

A material of the conductive particles CF1-2 is not particularly limited as long as it has the conductivity.

The conductive particles CF1-2 may include radical metal particles of various sizes. In the embodiment of the invention, 'the radical metal particles' are metal particles of a nearly spherical shape which contain at least one metal selected among copper (Cu), silver (Ag), gold (Au), iron (Fe), nickel (Ni), lead (Pb), zinc (Zn), cobalt (Co), titanium (Ti), and magnesium (Mg) as the main component and each have a plurality of protrusions non-uniformly formed on its surface.

The first conductive adhesive film CF1 may include at least one radical metal particle having the size greater than a thickness of the resin CF1-1, so that a current smoothly flows between the first electrode 112 and the interconnector 120.

According to the above-described configuration of the first conductive adhesive film CF1, a portion of the radical metal particle having the size greater than the thickness of the resin CF1-1 is buried in the first electrode 112 and/or the interconnector 120.

Accordingly, a contact area between the radical metal particle and the first electrode 112 and/or a contact area between the radical metal particle and the interconnector 120 increase, and a contact resistance decreases. The reduction in the contact resistance makes the current flow between the first electrode 112 and the interconnector 120 smooth.

So far, the embodiment of the invention, in which the radical metal particles are used as the conductive particles CF1-2, was described. However, the conductive particles CF1-2 may be metal-coated resin particles containing at least one metal selected among copper (Cu), silver (Ag), gold (Au), iron (Fe), nickel (Ni), lead (Pb), zinc (Zn), cobalt (Co), titanium (Ti), and magnesium (Mg) as the main component.

When the conductive particles CF1-2 are the metal-coated resin particles, each of the conductive particles CF1-2 may have a circle shape or an oval shape.

The conductive particles CF1-2 may physically contact one another.

It is preferable, but not required, that a composition amount of the conductive particles CF1-2 distributed in the resin CF1-1 is about 0.5 % to 20 % based on the total volume of the first conductive adhesive film CF1 in consideration of the connection reliability after the resin CF1-1 is cured.

When the composition amount of the conductive particles CF1-2 is less than about 0.5 %, the current may not smoothly flow because of a reduction in a physical contact area between the first electrode 112 and the interconnector 120. When the composition amount of the conductive particles CF1-2 is greater than about 20 %, the adhesive strength between the first electrode 112 and the interconnector 120 may be reduced because a composition amount of the resin CF1-1 relatively decreases.

The first conductive adhesive film CF1 is attached to one end of the first electrode 112 in a direction parallel to the first electrode 112.

A tabbing process is used to bond the first electrode 112 to the interconnector 120. The tabbing process includes a pre-bonding process for bonding the first conductive adhesive film CF1 to one end of the first electrode 112 and a final-bonding process for bonding the first conductive adhesive film CF1 to the interconnector 120.

When the tabbing process is performed using the first conductive adhesive film CF1, a heating temperature and a pressure of the tabbing process are not particularly limited as long as they are set within the range capable of securing an electrical connection and maintaining the adhesive strength.

For example, the heating temperature in the pre-bonding process may be set to be equal to or less than about 100 °C, and the heating temperature in the final-bonding process may be set to a curing temperature of the resin CF1-1, for example, about 140 °C to 180 °C.

Further, the pressure in the pre-bonding process may be set to about 1 MPa. The pressure in the final-bonding process may be set to a range capable of sufficiently bonding the first electrode 112 and the interconnector 120 to the first conductive adhesive film CF1, for example, about 2 MPa to 3MPa.

In this instance, the pressure may be set so that at least a portion of the conductive particles CF1-2 is buried in the first electrode 112 and/or the interconnector 120.

Time required to apply heat and pressure in the pre-bonding process may be set to about 5 seconds. Time required to apply heat and pressure in the final-bonding process may be set to the extent that the first electrode 112, the interconnector 120, etc., are not damaged or deformed by heat, for example, about 10 seconds.

A width of the first conductive adhesive film CF1 in the second direction Y-Y' may be equal to or less than a width of the first electrode 112. A width of the second conductive adhesive film CF2 in the second direction Y-Y' may be equal to or less than a width of the second electrode 113.

One end of the first conductive adhesive film CF1 is positioned in a space between one end of the second electrode 113 and the interconnector 120, and the other end of the first conductive adhesive film CF1 corresponds with an edge of the substrate 111.

Alternatively, the other end of the first conductive adhesive film CF1 may be positioned inside the edge of the substrate 111.

FIG. 2 illustrates that the first conductive adhesive film CF1 and the second conductive adhesive film CF2 contact the substrate 111. However, because the back passivation layer 116b is positioned on the surface of the substrate 111, the first conductive adhesive film CF1 and the second conductive adhesive film CF2 do not directly contact the substrate 111.

According to the above-described configuration of the conductive adhesive film, the first conductive adhesive film CF1 does not contact the second electrode 113, and the second conductive adhesive film CF2 does not contact the first electrode 112.

A width of the interconnector 120 may be greater than a distance between the adjacent first and second conductive adhesive films CF1 and CF2. The width of the interconnector 120 may be properly set in consideration of an overlap area between the interconnector 120 and the first conductive adhesive film CF1 and an overlap area between the interconnector 120 and the second conductive adhesive film CF2.

The interconnector 120 may have a slit or a hole, so as to reduce a strain resulting from contraction and expansion by the heat in other embodiments of the invention.

When the back encapsulant 140 is formed of cured siloxane, the back encapsulant 140 may be filled in a space between the two adjacent back contact solar cells 110.

Alternatively, when the front encapsulant 130 and the back encapsulant 140 are formed of EVA or cured siloxane, the front encapsulant 130 may be filled in the space between the two adjacent back contact solar cells 110. Both the front encapsulant 130 and the back encapsulant 140 may be filled in the space depending on the material of the front encapsulant 130 and the back encapsulant 140.

The solar cell module having the above-described configuration may be manufactured by forming the front encapsulant 130 on the transparent member 150, disposing the plurality of back contact solar cells 110 on the front encapsulant 130 at uniform intervals therebetween, respectively disposing the first conductive adhesive film CF1 and the second conductive adhesive film CF2 on one end of the first electrode 112 and one end of the second electrode 113, tabbing the interconnector 120 to the first and second conductive adhesive films CF1 and CF2, forming the back encapsulant 140 thereon, disposing the back sheet 160 on the back encapsulant 140, and performing a lamination process.

In this instance, the front encapsulant 130 and the back encapsulant 140 may be formed by coating and curing liquid siloxane precursor, for example, dimethylsilyl oxy acrylate.

When the liquid siloxane precursor is coated, a portion of the coated liquid siloxane precursor is filled in a space between the adjacent back contact solar cells 110. In the solar cell module shown in FIG. 2, the back encapsulant 140 extends from the front encapsulant 130 to the interconnector 120.

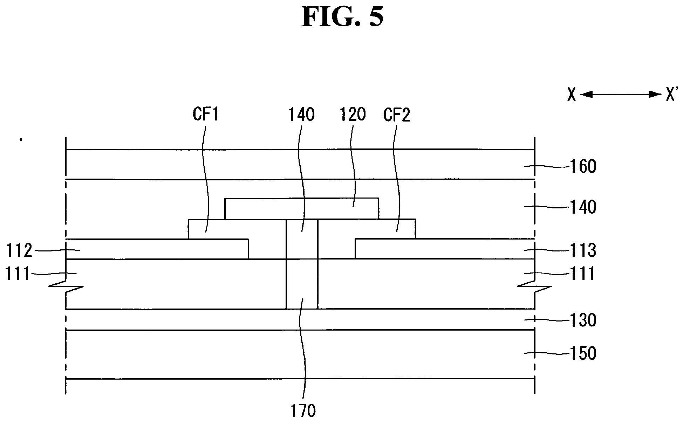

A modification of the solar cell module shown in FIG. 2 is described with reference to FIG. 5. Structures and components identical or equivalent to those in the first embodiment of the invention are designated with the same reference numerals, and a further description may be briefly made or may be entirely omitted.

Configuration of the solar cell module shown in FIG. 5 is substantially the same as the solar cell module shown in FIG. 2, except that a spacer 170 is positioned between the two adjacent substrates 111. As shown in FIG. 5, the spacer 170 may be positioned between the two adjacent substrates 111. In this instance, the spacer 170 may have the same thickness as the substrate 111. Alternatively, the spacer 170 may have a thickness corresponding to a sum of the thickness of the substrate 111 and a thickness of the conductive adhesive film CF1 or CF2.

When the thickness of the spacer 170 is substantially equal to the thickness of the substrate 111, at least one of the front encapsulant 130 and the back encapsulant 140 may be filled in a space between the spacer 170 and the interconnector 120. In the embodiment of the invention shown in FIG. 5, the spacer 170 extends from the front encapsulant 130 to the back encapsulant 140, and the back encapsulant 140 extends from the spacer 170 to the interconnector 120.

In the embodiment of the invention, a distance and electrical insulation between the adjacent back contact solar cells 110 are carried out by the spacer 170. Thus, the interconnector 120 may be viewed through a space between the adjacent back contact solar cells 110 when viewed at a light receiving surface of the solar cell module.

The interconnector 120 is formed of conductive metal of a color different from the back contact solar cells 110. Thus, the surface of the spacer 170 toward the light receiving surface of the solar cell module may be processed in the same color (for example, black or white) as the crystalline semiconductor substrate 111 or the back sheet 160, so as to improve an appearance of the solar cell module.

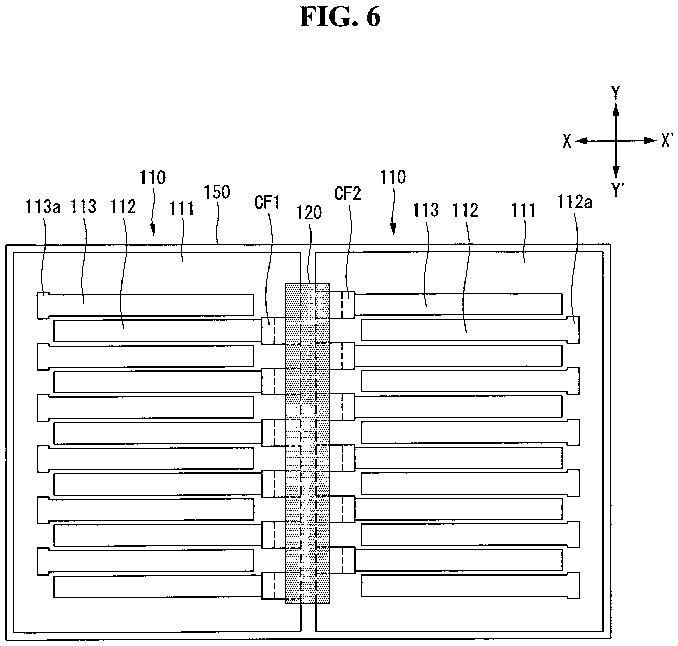

A solar cell module according to a second embodiment of the invention is described below with reference to FIG. 6.

Configuration of the second embodiment of the invention is substantially the same as the first embodiment of the invention, except that one end of each first electrode 112 and one end of each second electrode 113 respectively include a contact part 112a and a contact part 113a, each of which has a width greater than other portions of the first and second electrodes 112 and 113, and widths of first and second conductive adhesive films CF1 and CF2 are substantially equal to the widths of the contact parts 112a and 113a. Structures and components identical or equivalent to those in the first embodiment of the invention are designated with the same reference numerals, and a further description may be briefly made or may be entirely omitted.

In the solar cell module according to the second embodiment of the invention, because an area of the first and second electrodes 112 and 113 contacting the first and second conductive adhesive films CF1 and CF2 further increases than the first embodiment of the invention, a contact resistance between the first and second electrodes 112 and 113 and the first and second conductive adhesive films CF1 and CF2 and a contact resistance between the first and second conductive adhesive films CF1 and CF2 and an interconnector 120 are reduced.

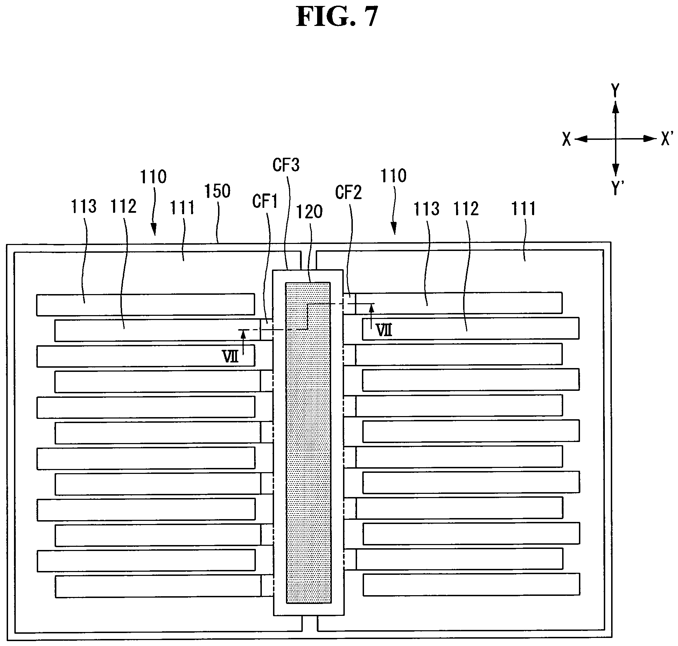

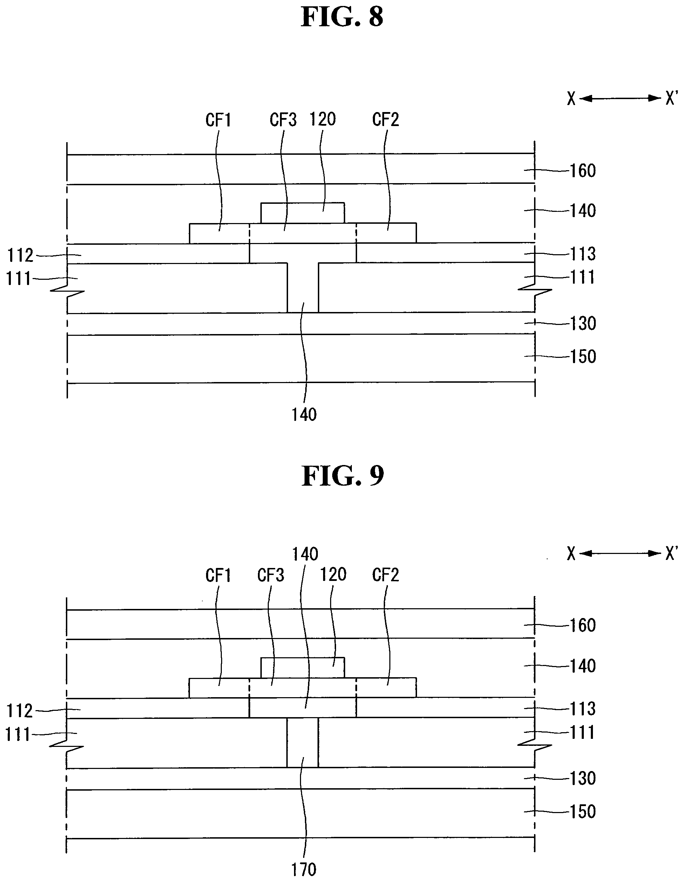

A solar cell module according to a third embodiment of the invention is described below with reference to FIGS. 7 and 8.

Configuration of the third embodiment of the invention is substantially the same as the first embodiment of the invention, except that it further includes a third conductive adhesive film CF3.

The third conductive adhesive film CF3 forms an integral body along with a plurality of first conductive adhesive films CF1 and a plurality of second conductive adhesive films CF2. The third conductive adhesive film CF3 extends in the second direction Y-Y'.

A width of the third conductive adhesive film CF3 may be equal to or less than a width of an interconnector 120. Alternatively, the width of the third conductive adhesive film CF3 may be greater than the width of an interconnector 120.

A length of the third conductive adhesive film CF3 may be equal to or greater than a length of the interconnector 120. A thickness of the third conductive adhesive film CF3 may be substantially equal to a thickness of the first conductive adhesive film CF1 and a thickness of the second conductive adhesive film CF2.

The surface of the third conductive adhesive film CF3 toward a light receiving surface of the solar cell module may be black or white in the same manner as the spacer 170. At least one of the front encapsulant 130 and the back encapsulant 140 may be filled in a space between back contact solar cells 110. In the solar cell module shown in FIG. 8, the back encapsulant 140 extends from the front encapsulant 130 to the third conductive adhesive film CF3.

Various modifications of the solar cell module shown in FIG. 8 are described below with reference to FIGS. 9 to 11.

FIG. 9 illustrates a first modification of the solar cell module shown in FIG. 8. Configuration of the solar cell module shown in FIG. 9 is substantially the same as the solar cell module shown in FIG. 8, except that a spacer 170 is formed in a space between the adjacent substrates 111. In the solar cell module shown in FIG. 9, the spacer 170 extends from the front encapsulant 130 to the back encapsulant 140, and the back encapsulant 140 extends from spacer 170 to the third conductive adhesive film CF3.

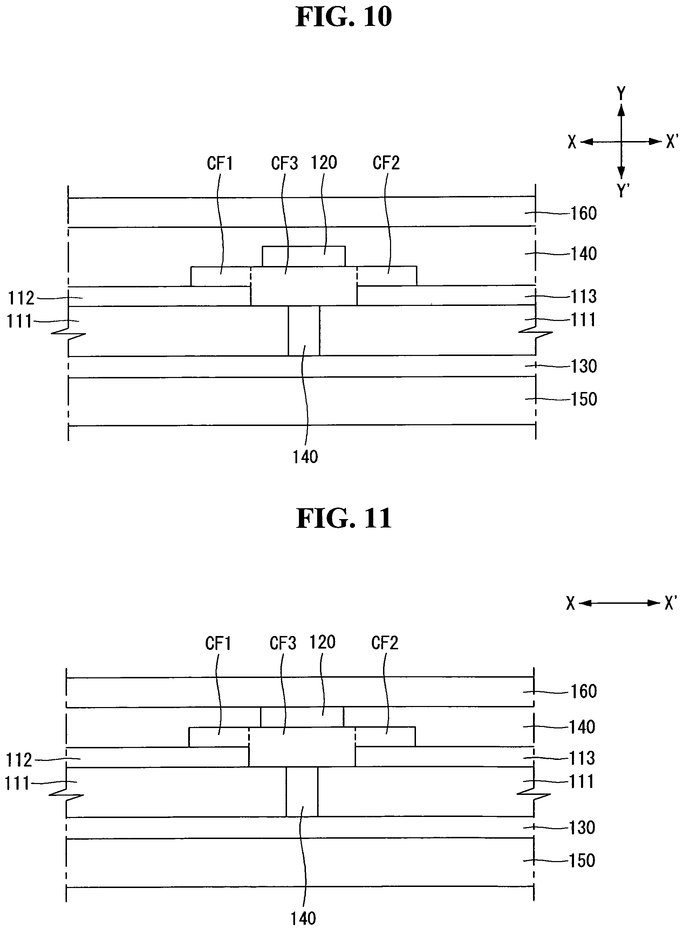

FIG. 10 illustrates a second modification of the solar cell module shown in FIG. 8. Configuration of the solar cell module shown in FIG. 10 is substantially the same as the solar cell module shown in FIG. 8, except that a thickness of the third conductive adhesive film CF3 is greater than a thickness of the first conductive adhesive film CF1 and a thickness of the second conductive adhesive film CF2.

For example, the thickness of the third conductive adhesive film CF3 may be substantially equal to a sum of the thickness of the conductive adhesive film CF1 or CF2 and a thickness of the electrode 112 or 113. In this instance, at least one of the front encapsulant 130 and the back encapsulant 140 may be filled in a space between the substrates 111.

The back passivation layer 116b is positioned on the surface of the substrate 111 contacting the third conductive adhesive film CF3.

FIG. 11 illustrates a third modification of the solar cell module shown in FIG. 8. Configuration of the solar cell module shown in FIG. 11 is substantially the same as the solar cell module shown in FIG. 8, except that the interconnector 120 is formed using a conductive pattern formed on the back sheet 160.

As described above, when the interconnector 120 is formed using the conductive pattern formed on the back sheet 160, a separate tabbing process for tabbing the interconnector 120 to the conductive adhesive film is unnecessary. Further, the number of module processes may be reduced by tabbing the conductive pattern to the conductive adhesive film in a lamination process.

Accordingly, the solar cell modules shown in FIGS. 10 and 11, the back encapsulant 140 extends from the front encapsulant 130 to the third conductive adhesive film CF3.

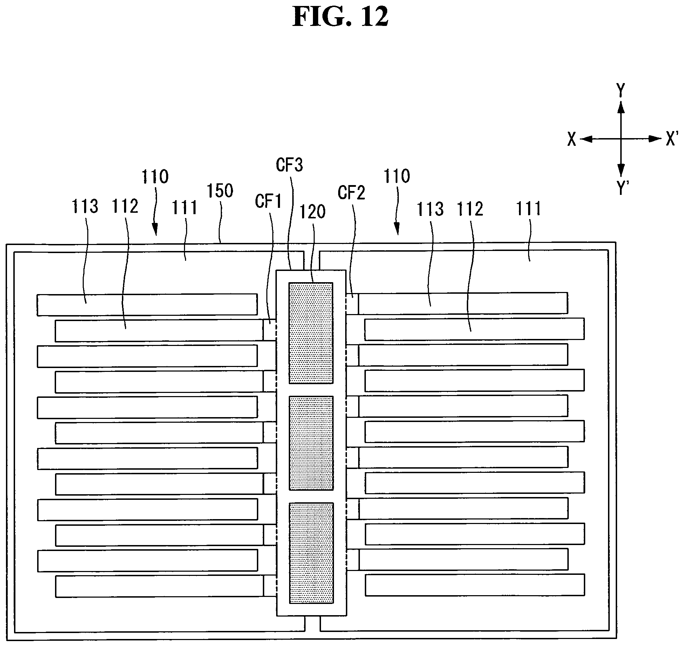

A solar cell module according to a fourth embodiment of the invention is described below with reference to FIG. 12.

Configuration of the solar cell module according to the fourth embodiment of the invention is substantially the same as the solar cell module shown in FIG. 8, except adjacent back contact solar cells 110 are electrically connected to each other using a plurality of interconnectors 120.

As shown in FIG. 12, at least two interconnectors 120 are positioned on a third conductive adhesive film CF3 in a longitudinal direction of the third conductive adhesive film CF3, i.e., in the second direction Y-Y'.

## Claims

1. A solar cell module comprising:
a plurality of back contact solar cells (110) each including a crystalline semiconductor substrate (111) having a first conductivity type; a passivation layer on a back surface of the crystalline semiconductor substrate;
a plurality of emitter regions (119a) positioned on the passivation layer and forming a pn junction and a hetero junction with the crystalline semiconductor substrate; a plurality of back surface field regions (119b) positioned on the passivation layer, spaced apart from the plurality of emitter regions and forming a hetero junction with the crystalline semiconductor substrate;
a plurality of first electrodes (112) electrically connected to the plurality of emitter regions and extending in a first direction; and a plurality of second electrodes (113) electrically connected to the plurality of back surface field regions and extending in the first direction;
an interconnector (120) which is positioned between two adjacent back contact solar cells (110), extends in a direction perpendicular to the first direction and electrically connects the plurality of first electrodes of one cell of the two adjacent back contact solar cells (110) and the plurality of second electrodes of the other cell of the two adjacent back contact solar cells;
a plurality of first conductive adhesive films (CF1) positioned between a contact part of the plurality of first electrodes (112) of one of the two adjacent back contact solar cells (110) and the interconnector;
a plurality of second conductive adhesive films (CF2) positioned between a contact part of the plurality of second electrodes (113) of the other of the two adjacent back contact solar cells (110) and the interconnector;
a front encapsulant (130) and a back encapsulant (140) configured to protect the plurality of back contact solar cells (110);
a transparent member (150) positioned on the front encapsulant (130) on front surfaces of the substrates (111) of the plurality of back contact solar cells (110); and
a back sheet (160) positioned under the back encapsulant (140) on the back surfaces of the substrates (111) of the plurality of back contact solar cells (110),
**characterized in that**,
the plurality of emitter regions (119a) and the plurality of back surface field regions (119b) are formed of amorphous silicon,
each of the first conductive adhesive film and the second conductive adhesive film is formed of conductive particles dispersed into a resin, and
the interconnector is electrically contacted with the first conductive adhesive film and the second conductive adhesive film.

2. The solar cell module of claim 1, wherein a width of the contact part of each of the first and second electrodes (112, 113) which is in contact with the interconnector is more than a width of parts of the first and second electrodes (112, 113) which are not in contact with the interconnector.

3. The solar cell module of claim 1, wherein the first conductive adhesive film (CF1) is positioned on the first electrode (112) and on the semiconductor substrate (111) at a portion where the first electrode (112) is not formed, and the second conductive adhesive film (CF2) is positioned on the second electrode (113) and on the semiconductor substrate (111) at a portion where the second electrode (113) is not formed.

4. The solar cell module of any one preceding claim, wherein a width of each of the plurality of first conductive adhesive films (CF1) is equal to or less than the width of the contact part of the plurality of first electrodes (112), and a width of each of the plurality of second conductive adhesive films (CF2) is equal to or less than the width of the contact part of the plurality of second electrodes (113).

5. The solar cell module of any one preceding claim, wherein the interconnector (120) is formed using a conductive pattern formed on the back sheet (160).

6. The solar cell module of any one preceding claim, wherein a spacer (170) is positioned between the substrates (111) of the two adjacent back contact solar cells.

7. The solar cell module of any one preceding claim, further comprising a third conductive adhesive film (CF3) which forms an integral body along with the plurality of first conductive adhesive films (CF1) and the plurality of second conductive adhesive films (CF2) and extends in the direction of the interconnector,
wherein the interconnector (120) is in direct contact with the third conductive adhesive film (CF3).

8. The solar cell module of claim 7, wherein a length of the third conductive adhesive film (CF3) is equal to or greater than a length of the interconnector (120).

9. The solar cell module of claim 7 or 8, wherein the third conductive adhesive film (CF3) has a black or white surface.

10. The solar cell module of any one of claims 7 to 9, wherein a thickness of the third conductive adhesive film (CF3) is substantially equal to a thickness of one first conductive adhesive film (CF1) and a thickness of one second conductive adhesive film (CF2), or is greater than the thickness of the one first conductive adhesive film (CF1) and the thickness of the one second conductive adhesive film (CF2).

11. The solar cell module of claim 10, wherein the thickness of the third conductive adhesive film (CF3) is substantially equal to a sum of a thickness of one first electrode (112) and the thickness of the one first conductive adhesive film (CF1).

12. The solar cell module of any one preceding claim, wherein the interconnector (120) has a slit or a hole.

13. The solar cell module of any one preceding claim, wherein the first conductive adhesive film (CF1) is positioned on an edge part of the one of the two adjacent back contact solar cells (110) and the second conductive adhesive film (CF2) is positioned on an edge part of the other one of the two adjacent back contact solar cells (110).

14. The solar cell module of any one preceding claim, further comprising,
a front surface field region (117) is positioned on a front surface of the crystalline semiconductor substrate (111), and
an anti-reflection layer (118) is positioned on the front surface of the crystalline semiconductor substrate (111).

## Patentansprüche

1. Solarzellenmodul umfassend:
eine Mehrzahl von Rückkontakt-Solarzellen (110), die jeweils umfassen:
ein kristallines Halbleitersubstrat (111) eines ersten Leitungstyps;
eine Passivierungsschicht auf einer Rückseite des kristallinen Halbleitersubstrats;
eine Mehrzahl von Emitterbereichen (119a), welche auf der Passivierungsschicht angeordnet sind und mit dem kristallinen Halbleitersubstrat einen p-n-Übergang und einen Heteroübergang bilden;
eine Mehrzahl von Rückseitenfeldbereichen (119b) welche an der Passivierungsschicht angeordnet sind, räumlich von der Mehrzahl von Emitterbereichen getrennt sind und einen Heteroübergang mit dem kristallinen Halbleitersubstrat bilden;
eine Mehrzahl erster Elektroden (112), welche mit der Mehrzahl von Emitterbereichen elektrisch verbunden ist und sich in einer ersten Richtung erstreckt; und
eine Mehrzahl zweiter Elektroden (113) die mit der Mehrzahl von Rückseitenfeldbereichen elektrisch verbunden ist und sich in der ersten Richtung erstreckt;
einen Verbinder (120), welcher zwischen zwei aneinander angrenzenden Rückkontakt-Solarzellen (110) angeordnet ist, sich in einer Richtung senkrecht zu der ersten Richtung erstreckt und die Mehrzahl erster Elektroden einer Zelle der beiden benachbarten Rückkontakt-Solarzellen (110) und die Mehrzahl zweiter Elektroden der anderen Zelle der beiden benachbarten Rückkontakt-Solarzellen elektrisch verbindet;
eine Mehrzahl erster leitfähiger Adhäsivfilme (CF1), welche zwischen einem Kontaktteil der Mehrzahl von ersten Elektroden (112) einer der beiden benachbarten Rückkontakt-Solarzellen (110) und dem Verbinder angeordnet ist;
eine Mehrzahl zweiter leitfähiger Adhäsivfilme (CF2), welche zwischen einem Kontaktteil der Mehrzahl von zweiten Elektroden (113) der anderen der beiden benachbarten Rückkontakt-Solarzellen (110) und dem Verbinder angeordnet ist;
ein vorderes Einkapselungsmittel (130) und ein rückseitiges Einkapselungsmittel (140), welche dazu eingerichtet sind, die Mehrzahl von Rückkontakt-Solarzellen (110) zu schützen;
ein transparentes Element (150), welches an dem vorderen Einkapselungsmittel (130) auf den Vorderseiten der Substrate (111) der Mehrzahl von Rückkontakt-Solarzellen (110) angeordnet ist; und
eine rückseitige Lage (160), welche unter dem rückseitigen Einkapselungsmittel (140) auf den Rückseiten der Substrate (111) der Mehrzahl von Rückkontakt-Solarzellen (110) angeordnet ist,
**dadurch gekennzeichnet, dass**
die Mehrzahl von Emitterbereichen (119a) und die Mehrzahl von Rückseitenfeldbereichen (119b) aus amorphem Silizium gebildet sind,
sowohl der erste leitfähige Adhäsivfilm, als auch der zweite leitfähige Adhäsivfilm aus leitfähigen Partikeln gebildet ist, welche in ein Harz dispergiert sind, und
der Verbinder mit dem ersten leitfähigen Adhäsivfilm und dem zweiten leitfähigen Adhäsivfilm elektrisch in Kontakt steht.

2. Solarzellenmodul nach Anspruch 1, wobei eine Breite des Kontaktteils jeder der ersten und zweiten Elektroden (112, 113), die mit dem Verbinder in Kontakt steht, größer ist, als eine Breite der Teile der ersten und zweiten Elektrode (112, 113), die nicht mit dem Verbinder in Kontakt steht.

3. Solarzellenmodul nach Anspruch 1, wobei der erste leitfähige Adhäsivfilm (CF1) an der ersten Elektrode (112) und an dem Halbleitersubstrat (111) an einem Abschnitt angeordnet ist, an welchem die erste Elektrode (112) nicht gebildet ist, und der zweite leitfähige Adhäsivfilm (CF2) an der zweiten Elektrode (113) und an dem Halbleitersubstrat (111) an einem Abschnitt angeordnet ist, an welchem die zweite Elektrode (113) nicht gebildet ist.

4. Solarzellenmodul nach einem der vorhergehenden Ansprüche, wobei eine Breite jedes der Mehrzahl erster leitfähiger Adhäsivfilme (CF1) gleich oder kleiner ist, als die Breite des Kontaktteils der Mehrzahl von ersten Elektroden (112), und wobei eine Breite jedes der Mehrzahl zweiter leitfähiger Adhäsivfilme (CF2) gleich oder kleiner ist, als die Breite des Kontaktteils der Mehrzahl von zweiten Elektroden (113).

5. Solarzellenmodul nach einem der vorhergehenden Ansprüche, wobei der Verbinder (120) unter Verwendung eines auf der rückseitigen Lage (160) gebildeten leitfähigen Musters gebildet ist.

6. Solarzellenmodul nach einem der vorhergehenden Ansprüche, wobei ein Abstandshalter (170) zwischen den Substraten (111) der zwei benachbarten Rückkontakt-Solarzellen angeordnet ist.

7. Solarzellenmodul nach einem der vorhergehenden Ansprüche, welches ferner einen dritten leitfähigen Adhäsivfilm (CF3) umfasst, welcher einen integralen Körper zusammen mit der Mehrzahl erster leitfähiger Adhäsivfilme (CF1) und der Mehrzahl zweiter leitfähiger Adhäsivfilme (CF2) bildet und sich in der Richtung des Verbinders erstreckt,
wobei der Verbinder (120) in direktem Kontakt mit dem dritten leitfähigen Adhäsivfilm (CF3) steht.

8. Solarzellenmodul nach Anspruch 7, wobei eine Länge des dritten leitfähigen Adhäsivfilms (CF3) gleich oder größer ist, als eine Länge des Verbinders (120).

9. Solarzellenmodul nach Anspruch 7 oder 8, wobei der dritte leitfähige Adhäsivfilm (CF3) eine schwarze oder weiße Oberfläche aufweist.

10. Solarzellenmodul nach einem der Ansprüche 7 bis 9, wobei eine Dicke des dritten leitfähigen Adhäsivfilms (CF3) im Wesentlichen gleich einer Dicke eines einzelnen ersten leitfähigen Adhäsivfilms (CF1) und einer Dicke eines einzelnen zweiten leitfähigen Adhäsivfilms (CF2) ist, oder größer ist, als die Dicke des einen ersten leitfähigen Adhäsivfilms (CF1) und die Dicke des einen zweiten leitfähigen Adhäsivfilms (CF2).

11. Solarzellenmodul nach Anspruch 10, wobei die Dicke des dritten leitfähigen Adhäsivfilms (CF3) im Wesentlichen gleich einer Summe einer Dicke einer ersten Elektrode (112) und der Dicke des einen ersten leitfähigen Adhäsivfilms (CF1) ist.

12. Solarzellenmodul nach einem der vorhergehenden Ansprüche, wobei der Verbinder (120) einen Schlitz oder ein Loch aufweist.

13. Solarzellenmodul nach einem der vorhergehenden Ansprüche, wobei der erste leitfähige Adhäsivfilm (CF1) an einem Randteil der einen der beiden benachbarten Rückkontakt-Solarzellen (110) und der zweite leitfähige Adhäsivfilm (CF2) an einem Randteil der anderen der beiden benachbarten Rückkontakt-Solarzellen (110) angeordnet ist.

14. Solarzellenmodul nach einem der vorhergehenden Ansprüche, ferner umfassend, einen Vorderseitenfeldbereich (117), welcher auf einer Vorderseite des kristallinen Halbleitersubstrats (111) angeordnet ist, und
eine Antireflexionsschicht (118), welche auf der Vorderseite des kristallinen Halbleitersubstrats (111) angeordnet ist.

## Revendications

1. Module de piles solaires comprenant :
une pluralité de piles solaires à contact arrière (110) incluant chacune un substrat cristallin semi-conducteur (111) ayant un premier type de conductivité ; une couche de passivation sur une surface arrière du substrat cristallin semi-conducteur ;
une pluralité de régions d'émetteur (119a) positionnées sur la couche de passivation et formant une jonction pn et une hétéro-jonction avec le substrat cristallin semi-conducteur ; une pluralité de régions de champ de surface arrière (119b) positionnées sur la couche de passivation, espacées de la pluralité de régions d'émetteur et formant une hétéro-jonction avec le substrat cristallin semi-conducteur ;
une pluralité de premières électrodes (112) connectées électriquement à la pluralité de régions d'émetteur et s'étendant dans une première direction ; et une pluralité de secondes électrodes (113) connectées électriquement à la pluralité de régions de champ de surface arrière et s'étendant dans la première direction ;
un interconnecteur (120) qui est positionné entre deux piles solaires à contact arrière (110) adjacentes, s'étend dans une direction perpendiculaire à la première direction et connecte électriquement la pluralité de premières électrodes d'une pile des deux piles solaires à contact arrière (110) adjacentes et la pluralité de secondes électrodes de l'autre pile des deux piles solaires à contact arrière adjacentes ;
une pluralité de premiers films adhésifs conducteurs (CF1) positionnés entre une partie de contact de la pluralité de premières électrodes (112) de l'une des deux piles solaires à contact arrière (110) adjacentes et l'interconnecteur ;
une pluralité de deuxièmes films adhésifs conducteurs (CF2) positionnés entre une partie de contact de la pluralité de secondes électrodes (113) de l'autre des deux piles solaires à contact arrière (110) adjacentes et l'interconnecteur ;
un agent d'encapsulation avant (130) et un agent d'encapsulation arrière (140) configurés pour protéger la pluralité de piles solaires à contact arrière (110) ;
un élément transparent (150) positionné sur l'agent d'encapsulation avant (130) sur des surfaces avant des substrats (111) de la pluralité de piles solaires à contact arrière (110) ; et
une feuille arrière (160) positionnée sous l'agent d'encapsulation arrière (140) sur les surfaces arrière des substrats (111) de la pluralité de piles solaires à contact arrière (110),
**caractérisé en ce que**,
la pluralité de régions d'émetteur (119a) et la pluralité de régions de champ de surface arrière (119b) sont formées de silicium amorphe,
chacun du premier film conducteur adhésif et du deuxième film conducteur adhésif est formé de particules conductrices dispersées dans une résine, et
l'interconnecteur est électriquement mis en contact avec le premier film conducteur adhésif et le deuxième film conducteur adhésif.

2. Module de piles solaires selon la revendication 1, dans lequel une largeur de la partie de contact de chacune des première et seconde électrodes (112, 113) qui est en contact avec l'interconnecteur est supérieure à une largeur de parties des première et seconde électrodes (112, 113) qui ne sont pas en contact avec l'interconnecteur.

3. Module de piles solaires selon la revendication 1, dans lequel le premier film conducteur adhésif (CF1) est positionné sur la première électrode (112) et sur le substrat semi-conducteur (111) au niveau d'une partie où la première électrode (112) n'est pas formée, et le deuxième film conducteur adhésif (CF2) est positionné sur la seconde électrode (113) et sur le substrat semi-conducteur (111) au niveau d'une partie où la seconde électrode (113) n'est pas formée.

4. Module de piles solaires selon l'une quelconque des revendications précédentes, dans lequel une largeur de chacun de la pluralité de premiers films conducteurs adhésifs (CF1) est égale ou inférieure à la largeur de la partie de contact de la pluralité de premières électrodes (112), et une largeur de chacun de la pluralité de deuxièmes films conducteurs adhésifs (CF2) est égale ou inférieure à la largeur de la partie de contact de la pluralité de secondes électrodes (113).

5. Module de piles solaires selon l'une quelconque des revendications précédentes, dans lequel l'interconnecteur (120) est formé en utilisant un tracé conducteur formé sur la feuille arrière (160).

6. Module de piles solaires selon l'une quelconque des revendications précédentes, dans lequel un espaceur (170) est positionné entre les substrats (111) des deux piles solaires à contact arrière adjacentes.

7. Module de piles solaires selon l'une quelconque des revendications précédentes, comprenant en outre un troisième film conducteur adhésif (CF3) qui forme un corps intégral avec la pluralité de premiers films conducteurs adhésifs (CF1) et la pluralité de deuxièmes films conducteurs adhésifs (CF2) et s'étend dans la direction de l'interconnecteur,
dans lequel l'interconnecteur (120) est en contact direct avec le troisième film conducteur adhésif (CF3).

8. Module de piles solaires selon la revendication 7, dans lequel une longueur du troisième film conducteur adhésif (CF3) est égale ou supérieure à une longueur de l'interconnecteur (120).

9. Module de piles solaires selon la revendication 7 ou 8, dans lequel le troisième film conducteur adhésif (CF3) a une surface noire ou blanche.

10. Module de piles solaires selon l'une quelconque des revendications 7 à 9, dans lequel une épaisseur du troisième film conducteur adhésif (CF3) est sensiblement égale à une épaisseur d'un premier film conducteur adhésif (CF1) et à une épaisseur d'un deuxième film conducteur adhésif (CF2), ou est supérieure à l'épaisseur du premier film conducteur adhésif (CF1) et à l'épaisseur du deuxième film conducteur adhésif (CF2).

11. Module de piles solaires selon la revendication 10, dans lequel l'épaisseur du troisième film conducteur adhésif (CF3) est sensiblement égale à une somme d'une épaisseur d'une première électrode (112) et de l'épaisseur du premier film conducteur adhésif (CF1).

12. Module de piles solaires selon l'une quelconque des revendications précédentes, dans lequel l'interconnecteur (120) présente une fente ou un trou.

13. Module de piles solaires selon l'une quelconque des revendications précédentes, dans lequel le premier film conducteur adhésif (CF1) est positionné sur une partie de bord de l'une des deux piles solaires à contact arrière (110) adjacentes et le deuxième film conducteur adhésif (CF2) est positionné sur une partie de bord de l'autre des deux piles solaires à contact arrière (110) adjacentes.

14. Module de piles solaires selon l'une quelconque des revendications précédentes, comprenant en outre,
une région de champ de surface avant (117) est positionnée sur une surface avant du substrat cristallin semi-conducteur (111), et
une couche antireflet (118) est positionnée sur la surface avant du substrat cristallin semi-conducteur (111).
